# DEMANDE DE BREVET EUROPEEN

(11) **EP 4 822 943 A1**
(43) Date de publication de la demande: **14.10.2026**
(21) Numéro de dépôt: 26171380.4
(22) Date de dépôt: 09.04.2026
(51) Int. Cl.: H02J 7/84

(54) **PROCÉDÉ DE QUALIFICATION POUR LA QUALIFICATION DE L ÉTAT DE SANTÉ DES MODULES DES BATTERIES DE TYPE NICKEL-HYDRURE MÉTALLIQUE NIMH**

(30) Priorité: 10.04.2025 FR 2503834
(71) Demandeur: Be Energy, 84000 Avignon (FR)
(72) Inventeur: COSTE, Bertrand, 30400 VILLENEUVE LES AVIGNON (FR); AL MOHAMAD, AHMAD, 84000 AVIGNON (FR)
(74) Mandataire: Germain Maureau

(57) **Abrégé**

Procédé de qualification (P) mis en œuvre par un système de qualification et comprenant une phase de qualification (PQ1, PQ2) pour qualifier un état de santé (SOH1, SOH2) d'au moins un module d'une batterie NiMH. La phase de qualification comprend :
- une étape d'identification (EQ3) durant laquelle une variation de tension mesurée aux bornes de l'au moins un module, pendant une décharge de celui-ci précédant l'étape d'identification, est comparée au moyen d'une fonction de similarité à des variations de tension de référence contenues dans une base de données comprise dans le système de qualification, et associées chacune à un état de santé de référence ; et
- une étape de qualification (EQ4) durant laquelle l'état de santé de l'au moins un module est qualifié comme égal à l'état de santé de référence de la variation de tension de référence pour laquelle la fonction de similarité est la plus élevée.

## Description

### [Domaine technique]

L'invention se rapporte à un procédé de qualification.

Elle se rapporte plus particulièrement à un procédé de qualification pour la qualification de l'état de santé des modules de batterie que comprennent les batteries de type nickel-hydrure métallique (ou batterie NiMH).

L'invention se rapporte également à un système de qualification mettant en œuvre le procédé de qualification.

L'invention trouve une application favorite, et non limitative, pour la qualification de l'état de santés des modules de type cylindrique ou prismatique des batteries NiMH, lesquelles sont par exemple utilisées pour l'alimentation des véhicules hybrides électriques auto-rechargeables.

### [Etat de la technique]

De manière connue, les batteries des systèmes consistent en un ensemble de cellules électriques, appelées aussi accumulateurs, qui sont reliées électriquement entre elles, et qui permettent, selon des réactions électrochimiques réversibles, de convertir et stocker l'énergie électrique sous forme chimique lors d'une phase dite de charge, et de la restituer sous forme de courant continu lors d'une phase dite de décharge. Il est également courant de relier électriquement plusieurs cellules et de les intégrer dans un même cadre boîtier, les cellules formant ainsi une unité d'alimentation ou module ; puis de relier électriquement entre eux plusieurs modules pour former la batterie.

Parmi les cellules, on distingue notamment les cellules dites prismatiques dont la chimie est enfermée dans une enveloppe rectangulaire rigide (avec leurs feuilles d'électrodes empilées, enroulées, ou aplaties à l'intérieur de l'enveloppe) pour permettre efficacement et facilement leur empilement dans un module dit module prismatique ; et les cellules cylindriques dont la chimie est enfermée dans un boîtier cylindrique rigide de plus petites dimensions que le boîtier des cellules dites prismatiques, l'empilement de cellules cylindriques pouvant former des modules cylindriques.

Les cellules prismatiques sont utilisées pour des applications énergivores, par exemple pour l'alimentation des véhicules électriques. Les cellules cylindriques stockent moins d'énergie que les cellules prismatiques, mais : leurs petites dimensions, comparativement aux cellules prismatiques, les rendent plus facilement intégrables dans un système électriques/électroniques ; et elles fournissent plus de puissance, les rendant plus adaptées pour les applications hautes performances.

Il existe de nombreuses technologies de batterie, telles que les batteries plomb-acide et les batteries type nickel-hydrure métallique. Les batteries nickel-hydrure métallique (ou batterie NiMH) sont notamment utilisées pour l'alimentation des véhicules hybrides électriques auto-rechargeables.

Au cours de leur cycle de vie, les batteries nickel-hydrure métallique (plus précisément leurs modules et leurs cellules) sont amenées à effectuer, à plusieurs reprises, des charges et des décharges. Ces nombreux cycles de charge/décharge ont pour conséquence d'entraîner le vieillissement des modules des batteries, qui entraîne une diminution progressive de leur capacité, c'est-à-dire l'énergie susceptible d'être emmagasinée et restituée par le module. D'autres facteurs peuvent intervenir dans le vieillissement des modules. Par exemple, le vieillissement des modules, lorsqu'utilisés pour l'alimentation de véhicules hybrides électriques auto-rechargeables, peut être accéléré par le climat, les habitudes de conduites du conducteur (conduite agressive sollicitant davantage le moteur électrique du véhicule).

Le vieillissement d'un module de batterie est déterminé au moyen d'un facteur de mérite appelé état de santé (ou State of Health en anglais) qui correspond à un rapport, exprimé souvent en pourcentage, entre la capacité maximale du module à un instant t et la capacité maximale du module lorsqu'il était neuf. Autrement dit, l'état de santé d'un module neuf est égal à 100%.

En raison des enjeux écologiques actuels, de nombreuses solutions sont destinées au recyclage ou au réemploi des déchets industriels. C'est le cas des batteries pour lesquelles sont proposés des systèmes et des procédés de régénération. Les procédés de régénération visent à la restauration des capacités nominales des batteries, plus précisément des modules et des cellules, en vue d'éviter leur remplacement ou leur mise au rebut. Cependant, un procédé de régénération sera inefficace si l'état de santé du module est trop bas.

Ainsi, la détermination de l'état de santé d'un module permet de qualifier un module comme potentiellement apte à être régénéré ou non. Cette qualification permet ainsi de ne pas mettre en œuvre inutilement un procédé de régénération s'il s'avère que le module considéré est inapte à la régénération.

Dans l'existant sont proposés des procédés pour la qualification des modules NiMH et la détermination de leur état de santé, tel que celui décrit dans US 2016/0322675 A1. Cependant, ces procédés impliquent de soumettre le module à plusieurs cycles de charge complète et de décharge profonde. Outre que la mise en œuvre de ces plusieurs cycles de charge et de décharge profonde soit chronophage (elle peut durer jusqu'à une dizaine d'heure pour un module d'une batterie NiMH pour les véhicules hybrides électriques), elle sollicite fortement le module, ce qui entraîne (c'est-à-dire accélère) son vieillissement.

### [Résumé de l'invention]

A cette fin, l'invention propose un procédé de qualification permettant de déterminer avec précision l'état de santé des modules de batterie NiMH, tout en réduisant significativement le temps nécessaire à cette détermination et en sollicitant le module le moins possible.

Ainsi, l'invention se rapporte à un procédé de qualification pour qualifier un état de santé d'au moins un module d'une batterie de type nickel-hydrure métallique, lequel au moins un module comprenant plusieurs cellules mises en série, ledit procédé de qualification étant mis en œuvre par un système de qualification qui comprend une base de données et auquel est raccordé électriquement l'au moins un module, et ledit procédé de qualification comprenant au moins une phase de qualification à l'issue de laquelle est déterminé l'état de santé de l'au moins un module, laquelle phase de qualification comprenant les étapes successives suivantes :
- une étape de charge au cours de laquelle le système de qualification applique à l'au moins un module un courant de charge pendant une durée de charge ;
- une étape de décharge au cours de laquelle, pendant une durée de décharge, le système de qualification applique à l'au moins un module un courant de décharge et mesure simultanément une variation de tension aux bornes de l'au moins un module ;
- une étape d'identification durant laquelle le système de qualification compare la variation de tension aux bornes de l'au moins un module à des variations de tension de référence au moyen d'une fonction de similarité, lesquelles variations de tension de référence étant contenues dans la base de données et étant chacune associée à un état de santé de référence, puis identifie l'une des variations de tension de référence, dite variation de tension de référence proche, pour laquelle la fonction de similarité est la plus élevée ;
- une étape de qualification durant laquelle le système de qualification qualifie l'état de santé de l'au moins un module comme égal à l'état de santé de référence associé à la variation de tension de référence proche ;
l'au moins un module étant déterminé à l'issue de la phase de qualification comme potentiellement régénérable ou non régénérable en fonction de l'état de santé déterminé.

Les variations de tension de référence correspondent à des variations de tension mesurées aux bornes de modules dits de référence pour lesquels ont été appliquées les étapes de charge et de décharge tels que mises en œuvre dans le procédé de qualification ; et pour lesquels furent déterminés par la suite leur état de santé respectif, dit état de santé de référence. Pour chacun des modules de références caractérisés, sa variation de tension de référence a été enregistrée dans la base de donnée en étant associée à la valeur déterminée de son état de santé de référence. A noter que plusieurs variations de tension de référence distinctes/différentes peuvent être associées à une même valeur d'état de santé de référence.

Ainsi, lors de la mise en œuvre le procédé de qualification, et comme indiqué plus haut, la variation de tension d'un module en train d'être qualifié, une fois mesurée lors de l'étape de décharge, est ensuite comparée lors de l'étape d'identification aux différentes variations de tension contenues dans la base de données au moyen d'une fonction de similarité. En fonction du résultat de la fonction de similarité, il est déterminé si la variation de tension du module en cours de qualification est, en termes de comportement, éloignée d'une variation de tension de référence, ou bien relative proche de celle-ci voire identique.

Parmi les variations de tension de référence est ainsi identifiée une variation de tension de référence proche pour laquelle la fonction de similarité est la plus élevée, c'est-à-dire une variation de tension de référence présentant en termes de comportement le plus de similitude avec la variation de tension mesurée du module en cours de qualification. Au cours de l'étape de qualification, l'état de santé (plus précisément la valeur de l'état de santé) du module en cours de qualification est qualifié comme étant alors égal à l'état de santé de référence (plus précisément la valeur de l'état de santé de référence) associé à la variation de tension de référence proche.

En fonction de la valeur de l'état de santé déterminée, le module est déterminé comme potentiellement régénérable ; ou bien non régénérable. Le module est mis au rebut dans le cas où il est déterminé comme étant non régénérable. En effet, comme précisé précédemment, dans le cas d'un état de santé trop faible, la mise en œuvre d'une régénération du module serait inefficace, c'est-à-dire que le gain en capacité du module résultant la régénération serait insuffisant pour un fonctionnement nominal.

Avantageusement, la détermination de l'état de santé d'un module d'une batterie NiMH, au cours de l'étape de qualification, résulte de la mise en œuvre successive des étapes de charge, de décharge, puis d'identification telles que décrites ci-avant. Autrement dit, l'état de santé d'un module n'est pas déterminé suite à la mise en œuvre successive d'une pluralité de cycles comprenant chacun une charge complète du module et une décharge profonde de celui-ci.

Les étapes de charge et de décharge sont mises en œuvre respectivement pendant une durée de charge et une durée de charge. Autrement dit, le module en cours de qualification n'est pas nécessairement complètement chargé à l'issue de l'étape de charge ; et l'étape de décharge ne correspond pas à une décharge complète du module.

Avantageusement, la mise en œuvre de l'étape de charge permet de prévenir tout risque de surcharge du module qui pourrait entraîner la formation d'oxygène gazeux pouvant faire gonfler le module jusqu'à ce qu'il se rompt. La mise en œuvre de l'étape de décharge permet de prévenir tout risque de décharge excessive du module qui pourrait entraîner la formation d'hydrogène gazeux pouvant faire gonfler le module jusqu'à ce qu'il se rompt, ou bien encore par exemple la formation de moustaches métalliques, qui sont des structures minces en forme d'aiguille, qui peuvent court-circuiter le module et entrainer une diminution de sa capacité.

Autrement dit, le procédé de qualification permet avantageusement d'éviter d'endommager le module ou d'accélérer son vieillissement au cours de sa qualification.

Dans le contexte applicatif d'une qualification de l'état de santé d'un module de batterie NiMH d'un véhicule hybride électrique auto-rechargeable, la mise en œuvre successives des étapes du procédé de qualification dure avantageusement moins d'une dizaine de minutes, comparativement aux procédés de qualification usuels qui durent une dizaine d'heures. Le procédé de qualification de l'invention permet donc de qualifier beaucoup plus rapidement l'état de santé d'un module. Par conséquent, le procédé de qualification de l'invention permet avantageusement de qualifier successivement et plus rapidement les états de santé de plusieurs modules comparativement aux procédés de qualification usuels.

De plus, un gain de temps est procuré par le procédé de qualification de l'invention car il permet la qualification simultanée de l'état de santé de plusieurs modules.

Un autre avantage du procédé de qualification est de réduire drastiquement la consommation d'énergie de ou des équipement(s) utilisé(s) pour charger et décharger les modules. Dans le procédé de qualification de l'invention, ce ou ces équipement(s) consomme(nt) de l'énergie au cours d'une seule étape de charge et une seule étape de décharge, par ailleurs pour des durées de charge et décharge relativement courtes ; alors qu'ils consomment de l'énergie, dans les procédés de qualification usuel, au cours de plusieurs étapes de charge complète et plusieurs étapes de décharge.

Selon un mode de réalisation de l'invention, le courant de charge est un courant continu constant.

Selon un mode de réalisation de l'invention, le courant de décharge est un courant continu constant, qui est par exemple égal à 56 Ampère.

Dans un mode de réalisation de l'invention, le procédé de qualification comprend, avant l'étape d'identification, une étape de mesure durant laquelle le système de qualification mesure une valeur d'au moins un paramètre physique de l'au moins un module, où les variations de tension de référence contenues dans la base de données sont toutes associées à une valeur dudit au moins un paramètre physique, et dans lequel, durant l'étape d'identification, il est opéré une présélection des variations de tension de référence dont la valeur de l'au moins un paramètre physique est équivalente à la valeur de l'au moins un paramètre physique mesurée lors de l'étape de mesure.

Autrement dit, dans un mode de réalisation, a été mesuré pour chacun des modules de référence, durant sa caractérisation, au moins un paramètre physique (plus précisément une valeur d'au moins un paramètre physique).

Selon un exemple, l'étape de mesure se déroule après l'étape de décharge et avant l'étape d'identification, avec l'au moins un paramètre physique pouvant par exemple correspondre à une température de l'au moins un module.

Selon un autre exemple, l'étape de mesure est mise en œuvre préalablement à l'étape de charge, avec l'au moins un paramètre physique pouvant par exemple correspondre à une tension en circuit ouvert mesurée aux bornes de l'au moins un module.

Selon d'autres exemples, l'au moins un paramètre physique peut être mesuré pendant la mise en œuvre de l'étape de charge ou celle de l'étape de décharge, ou bien entre ces deux étapes.

Pour chaque module de référence, la valeur de l'au moins un paramètre physique a été enregistrée dans la base de données avec la variation de tension de référence ; de sorte à classer dans la base de données les variations de tension de référence en fonction de la valeur de l'au moins un paramètre physique.

Lors de l'application du procédé qualification de l'invention, l'au moins un paramètre physique est mesuré pour le module en train d'être qualifié préalablement à la mise en œuvre de l'étape d'identification (c'est-à-dire selon différents exemples pendant l'étape de charge, ou pendant l'étape de décharge, ou bien après l'étape de décharge). Puis, pendant l'étape d'identification, la variation de tension mesurée du module en train d'être qualifié est uniquement comparée aux variations de tension de référence associée à une valeur de l'au moins un paramètre physique qui est équivalente (c'est-à-dire selon un exemple égale ; ou bien selon un autre sensiblement égale à 10% près) à celle mesurée pour ledit module.

Cette présélection des variations de tension de référence en fonction de la valeur d'au moins un paramètre physique permet avantageusement d'accélérer l'étape d'identification, autrement dit de réduire la durée nécessaire à sa mise en œuvre, en limitant le nombre de comparaisons avec la variation de tension du module au moyen de la fonction de similarité.

Selon un mode de réalisation de l'invention, le procédé de qualification comprend une mesure du courant de charge durant l'étape de charge ; l'étape de charge étant stoppée lorsque le courant de charge dépasse un seuil de sécurité de courant de charge donné.

A cours de l'étape de charge, il y aurait un risque de surcharge de l'au moins un module en cours de qualification dans le cas où la valeur du courant de charge deviendrait supérieure au seuil de sécurité de courant de charge.

Le contrôle de la valeur du courant de charge, et l'arrêt de l'étape de charge lorsque le courant de charge dépasse le seuil de sécurité de courant de charge, permettent donc avantageusement de prévenir le risque de surcharge de l'au moins un module.

Selon un exemple, le courant de charge est mesuré en continu. Selon un autre exemple, le courant de charge est mesuré à intervalle régulier.

Selon un mode de réalisation de l'invention, la phase de qualification est mise en œuvre une première fois pour établir l'état de santé de l'au moins un module, appelé état de santé initial, et une seconde fois pour établir l'état de santé de l'au moins un module, appelé état de santé final, et entre les deux phases de qualification, dites respectivement première phase de qualification et deuxième phase de qualification, est mise en œuvre une phase de régénération comprenant successivement :
- une étape de décharge au cours de laquelle le système de qualification applique à l'au moins un module un courant de décharge et mesure simultanément la variation de tension aux bornes de l'au moins un module, l'étape de décharge étant mise en œuvre jusqu'à ce que la variation de tension aux bornes de l'au moins un module devienne inférieure ou égale à une tension seuil de module ;
- une étape de charge de régénération durant laquelle le système de qualification applique, pendant une durée de régénération prédéfinie, à l'au moins un module un courant de charge de régénération sous la forme d'un train d'impulsions comprenant des impulsions en courant successives définies par une amplitude d'impulsion et une durée d'impulsion, et
- une étape de repos durant laquelle l'au moins un module est laissé au repos de sorte que l'au moins un module présente une température inférieure ou égale à une température seuil basse ;

la phase de régénération et la deuxième phase de qualification étant mises en œuvre à la condition que le système de qualification ait déterminé que l'au moins un module est potentiellement régénérable à l'issue de la première phase de qualification ; et
le système de qualification déterminant, à l'issue de la deuxième phase de qualification, que l'au moins un module : est potentiellement régénérable lorsque l'état de santé final est supérieur à un seuil de santé minimal ; ou bien non régénérable lorsque l'état de santé final est inférieur ou égal au seuil de santé minimal.

Autrement dit, dans un mode de réalisation, le procédé de qualification, peut avantageusement comprendre, suite à une première qualification de l'état de santé, dit état de santé initial, de l'au moins module à l'issue de la mise en œuvre de la phase de qualification au cours d'une première phase de qualification, et lorsque l'au moins un module est déterminé comme potentiellement régénérable, une phase de régénération du module en vue de restaurer sa capacité nominale (ou du moins que le gain en capacité obtenu suite à la phase de régénération soit suffisant pour un fonctionnement correct/nominal de l'au moins un module).

De plus, la phase de régénération peut être appliquée à plusieurs modules simultanément. Autrement dit, le procédé de qualification de l'invention procure un gain de temps dans le contexte applicatif d'une régénération de plusieurs modules.

Comme indiqué ci-avant, suite à la phase de régénération, la phase de qualification est à nouveau mise en œuvre de sorte à déterminer un état de santé, dit final, de l'au moins un module. L'état de santé final de l'au moins un module, c'est-à-dire l'état de santé de l'au moins un module après régénération, est alors comparé à un seuil de santé minimal. L'au moins un module qualifié est déterminé comme potentiellement régénérable lorsque l'état de santé final est supérieur au seuil de santé minimal ; et considéré comme non régénérable autrement. L'au moins un module est mis au rebut lorsqu'il est qualifié comme étant non régénérable.

Au cours de l'application du train d'impulsion pendant l'étape de charge de régénération, la température (plus précisément, la température interne) de l'au moins un module augmente. Elle augmente également lors de l'application du courant de charge de l'étape de charge de la deuxième phase de qualification. C'est pourquoi, afin de prévenir tout risque de détérioration/d'endommagement de l'au moins un module pour cause de surchauffe/d'emballement thermique, la phase de régénération s'achève sur une étape de repos qui précède chronologiquement l'étape de charge de la deuxième phase de qualification. Ainsi, l'étape de repos permet avantageusement à la température interne de l'au moins un module de diminuer, donc à l'au moins un module de refroidir, avant application de courant de charge de l'étape de charge de la deuxième phase de qualification.

L'au moins un module est considéré comme ayant refroidi et apte à recevoir le courant de charge de l'étape de charge de la deuxième phase de qualification lorsque sa température devient inférieure à une température seuil basse.

Dans un mode de réalisation, le courant de décharge de l'étape de décharge de la phase de régénération est un courant continu constant.

Dans un mode de réalisation, la tension seuil de module est définie comme étant égale à 1 Volt/cellule. Par exemple, lorsque l'au moins un module comprend 6 cellules, la tension seuil de module est égale à 6 Volt. Autrement dit, l'étape de décharge de la phase de régénération se termine lorsque la variation de tension mesurée aux bornes de l'au moins module devient inférieure ou égale à 1V/cellule, et l'étape de charge de régénération commence alors.

Selon un mode de réalisation de l'invention, le seuil de santé minimal est supérieur ou égal à 0.8 fois un état de santé nominal de l'au moins un module, lequel état de santé nominal est par exemple égal à 1.

Selon un mode de réalisation de l'invention, parallèlement à l'étape de charge de régénération de la phase de régénération, le système de qualification met en œuvre au moins une étape de mesure parmi les étapes de mesure suivantes :
- mesurer la température de l'au moins un module, puis la comparer à une température seuil haute, ou
- mesurer une tension de l'au moins un module, puis la comparer à une autre tension seuil de module, ou
- mesurer l'amplitude d'impulsion des impulsions du courant de charge de régénération, puis la comparer à une amplitude seuil d'impulsion ;
le phase de régénération étant stoppée et la deuxième phase de qualification n'étant pas mise en œuvre lorsqu'au moins : la température de l'au moins un module est supérieure ou égale à la température seuil haute, ou la tension de l'au moins un module est supérieure ou égale à l'autre tension seuil de module, ou l'amplitude d'impulsion est supérieure ou égale à l'amplitude seuil d'impulsion.

L'au moins une étape de mesure mise en œuvre au cours de l'étape de charge de régénération de la phase de régénération permet de détecter :
- une surchauffe de l'au moins un module lorsque sa température devient supérieure ou égale à la température seuil haute ; et/ou
- une surtension causée par le train d'impulsion et risquant d'endommager l'au moins un module lorsque la tension à ses bornes devient supérieure à une autre tension seuil de module ; et/ou
- une surintensité de l'au moins un module pouvant l'endommager lorsque l'amplitude d'impulsion des impulsions est ou devient supérieure à une amplitude seuil d'impulsion.

Par définition, l'autre tension seuil de module est strictement supérieure à la tension seuil de module.

Le procédé de qualification pour la qualification de l'au moins un module est stoppé aussitôt qu'au moins une surchauffe, ou une surtension, ou une surintensité est détectée.

Autrement dit, et avantageusement, le procédé de qualification permet de prévenir les risques de surchauffe, de surtension, et de surintensité de l'au moins un module au cours de l'étape de charge de régénération, et donc de la phase de régénération. La phase de régénération est donc sécurisée.

Selon un exemple, l'au moins une étape de mesure est mise en œuvre en continu au cours de l'étape de charge de régénération. Selon un autre exemple, l'au moins une étape de mesure est mise en œuvre à intervalle régulier au cours de l'étape de charge de régénération.

Selon un mode de réalisation de l'invention, lorsque l'au moins un module est déterminé comme potentiellement régénérable à l'issue de la deuxième phase de qualification (laquelle a été précédée de la première phase de qualification et de la phase de régénération), le procédé de qualification comprend au moins une étape de décharge additionnelle durant laquelle le système de qualification applique, pendant une durée de décharge additionnelle prédéfinie, un courant de décharge additionnel à l'au moins un module, et mesure simultanément une tension instantanée de l'au moins un module ; l'au moins un module étant déterminé par le système de qualification comme :
- régénéré lorsque la tension instantanée est stable et supérieure à la tension seuil de module pendant la durée de décharge additionnelle, ou bien
- non régénéré lorsqu'au moins, pendant la durée de décharge additionnelle, la tension instantanée varie, ou est inférieure ou égale à la tension seuil de module.

Comme indiqué précédemment, lorsque l'état de santé final de l'au moins un module est supérieur au seuil de santé minimal, celui-ci est déterminé comme potentiellement régénérable. En effet, bien que le gain en capacité obtenu suite à la phase de régénération soit suffisant, il n'est pas garanti que l'au moins un module soit apte à fournir rapidement de la puissance sur de courtes durées.

C'est pourquoi, suite à la deuxième phase de qualification, lorsque l'état de santé final de l'au moins un module est déterminé comme régénérable, est mise en œuvre au moins une étape de décharge additionnelle durant laquelle, pendant une durée de décharge additionnelle, est appliqué un courant de décharge additionnel à l'au moins un module. L'au moins une étape de décharge additionnelle sert à évaluer les performances de l'au moins un module. L'au moins une étape de décharge additionnelle est donc un test en puissance de l'au moins un module.

Au cours de l'au moins une étape de décharge additionnelle est mesurée en continu une tension instantanée de l'au moins un module. Lorsque la tension instantanée est stable et supérieure à la tension seuil de module pendant la durée de décharge additionnelle, alors il est déterminé que l'au moins un module est régénéré et apte à fournir rapidement de la puissance sur une courte durée. Autrement, l'au moins un module est déterminé comme non régénéré, puis mis au rebut, lorsque la tension instantanée varie, ou est inférieure ou égale à la tension seuil de module pendant la durée de décharge additionnelle.

Dans un mode de réalisation, l'au moins une étape de décharge additionnelle reproduit les conditions réelles d'utilisation de l'au moins un module lorsqu'il alimente électriquement un véhicule hybride électrique auto-rechargeable.

Dans un mode de réalisation, lorsque l'au moins une étape de décharge additionnelle comprend plusieurs étapes de décharge additionnelles mises en œuvre successivement. L'au moins un module est déterminé comme régénéré lorsque la tension instantanée mesurée est stable et supérieure à la tension seuil de module pendant la durée de décharge additionnelle pour chacune des plusieurs étapes de décharge additionnelles. Inversement, l'au moins un module est déterminé comme non régénéré lorsque, pour au moins une étape de décharge additionnelle parmi les plusieurs étapes de charge additionnelles, la tension instantanée varie, ou est inférieure ou égale à la tension seuil de module pendant la durée de décharge additionnelle.

Lorsque l'au moins un module comprend plusieurs modules qui ont été déterminés comme potentiellement régénérable à l'issue de la deuxième phase de régénération, l'au moins une étape de décharge additionnelle peut avantageusement être appliquée simultanément à ces dits plusieurs modules potentiellement régénérables.

Selon un mode de réalisation de l'invention, l'au moins un module présente un état de charge, et le procédé de qualification comprend, à l'issue de l'au moins une étape de décharge additionnelle et lorsque l'au moins un module est déterminé comme étant régénéré, une étape de charge additionnelle durant laquelle le système de qualification applique à l'au moins un module un courant de charge additionnel jusqu'à ce que l'état de charge de l'au moins un module soit égal à une portion de l'état de santé final.

La mise en œuvre de l'au moins une étape de décharge additionnelle a pour conséquence de diminuer la capacité de l'au moins un module, c'est-à-dire de diminuer son état de charge. Pour rappel, l'état de charge d'un module est représentatif de la quantité d'énergie stockée à l'intérieur de celui-ci, et correspond à un ration entre son niveau de charge actuel sur sa capacité totale.

C'est pourquoi le procédé de qualification comprend, suite à l'étape de décharge additionnelle, et lorsque l'au moins un module est déterminé comme régénéré, une étape de charge additionnelle dans le but de charger l'au moins un module, c'est-à-dire pour augmenter son état de charge. L'au moins un module est chargé par application d'un courant de charge additionnel jusqu'à ce que son état de charge soit égal, en termes de valeur, à une portion de l'état de santé final de l'au moins un module.

Lorsque l'au moins un module comprend plusieurs modules qui ont été déterminés comme potentiellement régénérables à l'issue de la deuxième phase de régénération, l'au moins une étape de décharge additionnelle peut avantageusement être appliquée simultanément à ces dits plusieurs modules potentiellement régénérables.

Selon un mode de réalisation de l'invention, la portion de l'état de santé final est comprise entre 0,5 et 0,7 fois l'état de santé final. Dans un mode de réalisation particulier, la portion de l'état de santé final correspond à 0,6 fois l'état de santé final. Autrement dit, dans ce mode de réalisation particulier, l'étape de charge additionnelle se termine lorsque la valeur de l'état de charge de l'au moins un module est égale à 0,6 fois la valeur de l'état de santé final dudit au moins un module (qualifiée pour rappel lors de l'étape de qualification de la deuxième phase de qualification.

Selon un mode de réalisation, le procédé de qualification comprend une mesure du courant de charge additionnel durant l'étape de charge additionnelle ; l'étape de charge étant stoppée lorsque le courant de charge additionnel dépasse un autre seuil de sécurité donné.

Dans un mode de réalisation de l'invention, le courant de charge additionnel est un courant continu constant.

La mesure du courant de charge additionnel au cours de l'étape de charge additionnelle a pour finalité de prévenir le risque de surcharge de l'au moins un module lors de sa recharge.

Selon un mode de réalisation de l'invention, l'au moins un module comprend plusieurs modules tels que le procédé de qualification est mis en œuvre pour chacun des plusieurs modules de manière indépendante.

Comme précédemment indiqué, le procédé de qualification permet avantageusement, lorsque l'au moins un module comprend plusieurs modules, d'appliquer les phases de qualification et de régénération, ainsi que l'étape de décharge additionnelle et l'étape de charge additionnelle, à plusieurs modules simultanément.

Un autre avantage du procédé est de devoir être mis en œuvre de manière indépendante pour chacun des plusieurs modules. Autrement dit, les différentes phases et étapes que comprend le procédé de qualification peuvent ne pas être mises en œuvre pour tous les modules simultanément.

La mise en œuvre du procédé de qualification peut par exemple débuter pour un module (avec l'initiation de l'étape de charge par exemple) alors que d'autres sont déjà en cours de qualification (le procédé de qualification étant par exemple pour eux dans son étape d'identification ou de qualification).

De même, dans le mode de réalisation où le procédé de qualification comprend les première et deuxième phases de qualification et la phase de régénération, la qualification de l'état de santé initial d'un des plusieurs modules peut être en cours alors qu'un autre des plusieurs modules peut être en cours de régénération (avec l'application de la phase de régénération).

Selon un autre exemple, dans le contexte applicatif d'une mise en œuvre de la première phase de qualification pour qualifier l'état de santé initial de plusieurs modules, lorsque l'état de santé initial d'un module parmi les plusieurs modules est tel que ledit module est déterminé comme non régénérable, le procédé de qualification se termine uniquement pour ce module, mais se poursuit avec la phase de régénération pour les autres modules dont la qualification de l'état de santé initial aura permis de déterminer qu'ils sont potentiellement régénérables.

Selon un autre exemple, le procédé de qualification peut se terminer pour un module parmi plusieurs modules pour lequel une surchauffe, une surtension, ou une surintensité a été détectée, mais se poursuivre pour les autres modules.

Selon un mode de réalisation de l'invention, les plusieurs modules comprennent entre 2 modules et 60 modules.

Selon un mode de réalisation de l'invention, les plusieurs cellules de l'au moins un module sont des cellules cylindriques, ou des cellules prismatiques.

Autrement dit, le procédé de qualification peut être avantageusement appliqué pour la qualification (et, dans un mode de réalisation, la régénération) de modules de batterie NiMH comprenant des cellules cylindriques ou des cellules prismatiques.

L'invention concerne également un système de qualification pour une qualification d'au moins un module d'une batterie de type nickel-hydrure métallique, avec l'au moins un module comprenant plusieurs cellules mises en série, le système de qualification comprenant une base de données, au moins un générateur de courant de charge, au moins un générateur de courant de décharge et au moins une prise d'entrée pour raccorder électriquement l'au moins un module au système de qualification ; le système de qualification comprenant également une unité de contrôle au moins en communication avec la base de données, l'au moins un générateur de courant de charge et l'au moins un générateur de courant de décharge, laquelle unité de contrôle comprenant un programme contenant une liste d'instructions qui, lorsqu'elles sont exécutées par l'unité de contrôle, mettent en œuvre le procédé de qualification tel que précédemment décrit.

Dans un mode de réalisation, la base de données peut être comprise dans l'unité de contrôle ou elle peut être déportée (autrement dit à distance).

Dans un mode de réalisation, le système de qualification comprend :
- l'au moins un générateur de courant de charge qui est au moins en communication avec l'unité de contrôle, laquelle commande l'au moins un générateur de courant de charge pour générer, durant l'étape de charge, le courant de charge et le transmettre à l'au moins un module ; et
- l'au moins un générateur de courant de décharge qui est au moins en communication avec l'unité de contrôle, laquelle commande l'au moins un générateur de courant de décharge pour générer, durant l'étape de décharge, le courant de décharge et le transmettre à l'au moins un module.

Lorsque le procédé de qualification comprend les deux phases de qualification et la phase de régénération, le système de qualification peut comprendre au moins un générateur de courant de régénération qui est au moins en communication avec l'unité de contrôle, laquelle commande l'au moins un générateur de courant de charge de régénération pour générer, durant l'étape de charge de régénération, le courant de charge de régénération et le transmettre à l'au moins un module. Dans un exemple, l'au moins un générateur de courant de décharge délivrant le courant de décharge au cours de l'étape de décharge des phases de qualification délivre également à l'au moins un module le courant de décharge de la phase de régénération. Dans un autre exemple, l'au moins un générateur de courant de décharge comprend au moins deux générateurs de courant de décharge tels que l'un des au moins deux générateurs de courant de décharge délivre à l'au moins un module le courant de décharge de l'étape de décharge des phases de qualification, et l'autre des au moins deux générateurs de courant de décharge délivre à l'au moins un module le courant de décharge de l'étape de décharge de la phase de régénération.

Lorsque le procédé de qualification comprend l'étape de décharge additionnelle :
- l'unité de contrôle commande l'au moins un générateur de courant de décharge pour délivrer à l'au moins un module le courant de décharge additionnel ; ou bien
- le système de qualification comprend au moins un générateur de courant de décharge additionnel commandé par l'unité de contrôle pour délivrer à l'au moins un module ledit courant de décharge additionnel.

Similairement, lorsque le procédé de qualification comprend l'étape de charge additionnelle :
- l'unité de contrôle commande l'au moins un générateur de courant de charge pour délivrer à l'au moins un module le courant de charge additionnel ; ou bien
- le système de qualification comprend au moins un générateur de courant de charge additionnel commandé par l'unité de contrôle pour délivrer à l'au moins un module ledit courant de charge additionnel.

Dans un mode de réalisation, le système de qualification peut comprendre au moins un rack, lequel au moins un rack comprenant plusieurs prises d'entrée afin d'y brancher plusieurs modules, par exemple douze prises d'entrée afin que le système de qualification qualifie l'état de santé de douze modules. Dans un mode de réalisation, le système de qualification comprend cinq rack raccordés à l'unité de contrôle et comprenant chacun douze prises d'entrée de sorte que le système de qualification soit apte à qualifier l'état de santé de soixante modules simultanément.

Dans un mode de réalisation, l'au moins un rack est également utilisé pour la régénération de l'au moins un module qui est branché à lui.

L'au moins un rack peut comprendre l'au moins un générateur de courant de charge et l'au moins un générateur de courant de décharge. L'au moins un générateur de courant de charge et l'au moins un générateur de courant de décharge sont reliés à l'au moins un prise d'entrée par l'intermédiaire d'un moins un bus de distribution ; de sorte à délivrer respectivement au module branché à l'au moins une prise d'entrée le courant de charge et le courant de décharge durant la phase de qualification. Lorsque le procédé de qualification comprend la phase de régénération, l'au moins un générateur de courant de charge de régénération peut également être contenu à l'intérieur de l'au moins un rack ; avec l'au moins un générateur de courant de charge de régénération raccordé également à l'au moins une prise d'entrée par le biais d'au moins un bus de distribution.

Lorsque l'au moins un rack comprend plusieurs racks, chacun des plusieurs racks comprend au moins un générateur de courant de charge et au moins un générateur de courant de décharge.

L'au moins un générateur de courant de charge et l'au moins un générateur de courant de décharge génèrent respectivement le courant de charge et le courant de décharge suite à la réception de signaux de commandes en provenance de l'unité de contrôle.

Afin que l'au moins un générateur de courant de charge et l'au moins un générateur de courant de décharge reçoivent des signaux de commande en provenance de l'unité de contrôle, l'au moins un rack peut par exemple présenter une prise de sortie permettant le raccordement électrique à au moins une prise d'entrée que présente l'unité de contrôle. L'unité de contrôle peut également présenter plusieurs prises d'entrée de sorte être raccordée électriquement à la prise de sortie de plusieurs racks.

Dans un mode de réalisation, lorsque l'au moins un rack présente plusieurs racks, chacun des plusieurs racks peut présenter au moins une prise de parallélisation. Les plusieurs racks sont alors cascadés en raccordant, pour chacun des racks, leur au moins une prise de parallélisation à celle d'un autre des plusieurs racks. L'un d'eux est également raccordé physiquement à l'unité de contrôle. Ainsi, l'unité de contrôle va transmettre les signaux de commande au rack auquel elle est raccordée physiquement, lequel rack va ensuite relayer lesdits signaux de commande au rack auquel il est physiquement raccordé et ainsi de suite.

Dans un mode de réalisation, l'au moins un rack n'est pas raccordé physiquement à l'unité de contrôle, mais est en communication avec elle. La transmission des signaux de commande se fait alors au moyen d'un protocole de communication sans fil courte distance.

Le système de qualification comprend au moins un dispositif de mesure de variation de tension qui est au moins en communication avec l'unité de contrôle, et qui est associé à l'au moins un module. L'au moins un dispositif de mesure de variation de tension est conformé pour mesurer et transmettre à l'unité de contrôle la variation observée aux bornes de l'au moins un module au cours de l'étape de décharge de la phase de qualification. Lorsque l'au moins un module comprend plusieurs modules, un dispositif de mesure de variation de tension est associé distinctement à chacun des plusieurs modules. Lorsque le procédé de qualification comprend la phase de régénération, l'au moins un dispositif de mesure de variation de tension peut être également conformé pour mesurer et transmettre à l'unité de contrôle la variation de tension aux bornes de l'au moins un module pendant l'étape de décharge et l'étape de décharge de la phase de régénération.

Dans un mode de réalisation, le système de qualification peut comprendre au moins un capteur de courant conformé pour mesurer, au cours de l'étape de charge de la phase de qualification, le courant de charge et transmettre la valeur mesurée du courant de charge à l'unité de contrôle. Dans un exemple, l'au moins un capteur de courant est associé à l'au moins un générateur de courant de charge. Dans un autre exemple, l'au moins un capteur de courant est associé à l'au moins un module.

Lorsque le procédé de qualification comprend la phase de régénération, le système de qualification comprend au moins un capteur de température qui est associé à l'au moins un module. L'au moins un capteur de température est conformé pour mesurer et transmettre la température de l'au moins un module à l'unité de contrôle. Lorsque l'au moins un module comprend plusieurs modules, l'au moins un capteur de température comprend plusieurs capteurs de température associé chacun de manière distincte à un des plusieurs modules.

Dans différents modes de réalisation, lorsque le procédé de qualification comprend la phase de régénération, le système de qualification peut comprendre :
- au moins un capteur de tension qui est associé à l'au moins un module ; avec l'au moins un capteur de tension qui est conformé pour mesurer et transmettre la tension aux bornes de l'au moins un module à l'unité de contrôle ; et/ou
- au moins un capteur de courant associé à l'au moins un générateur de courant de charge de régénération qui est conformé pour mesurer et transmettre à l'unité de contrôle l'amplitude des impulsions du courant de charge de régénération.

Dans un mode de réalisation, le système de qualification peut comprendre au moins un capteur de tension qui est associé à l'au moins un module ; avec l'au moins un capteur de tension qui est conformé, pendant l'étape de décharge additionnelle, pour mesurer et transmettre la tension instantanée de l'au moins un module à l'unité de contrôle.

Dans un mode de réalisation dans lequel le procédé de qualification comprend l'étape de charge additionnelle :
- l'au moins un capteur de courant, lorsqu'il est associé à l'au moins un générateur de courant de charge et que ce dernier est aussi conformé pour générer également le courant de charge additionnel, mesure et transmet à l'unité de contrôle la valeur de le courant de charge additionnel ; ou
- l'au moins un capteur de courant, lorsqu'il est associé à l'au moins un module, mesure et transmet à l'unité de contrôle la valeur de le courant de charge additionnel ; ou
- le système de qualification comprend au moins un autre capteur de courant associé à l'au moins un générateur de courant de charge additionnel, lequel au moins un autre capteur de courant mesure et transmet à l'unité de contrôle le courant de charge additionnel.

### [Brève description des figures]

D'autres caractéristiques et avantages de la présente invention apparaîtront à la lecture de la description détaillée ci-après, d'un exemple de mise en œuvre non limitatif, faite en référence aux figures annexées dans lesquelles :
[Fig 1] est un logigramme du procédé de qualification dans un mode de réalisation ;
[Fig 2] est une vue schématique, dans un mode de réalisation, du système de qualification mettant en œuvre le procédé de qualification.

### [Description détaillée d'un ou plusieurs modes de réalisation de l'invention]

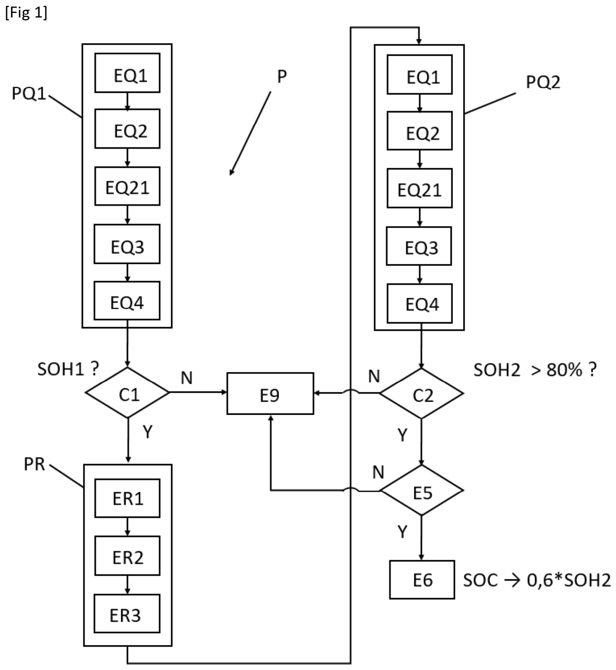

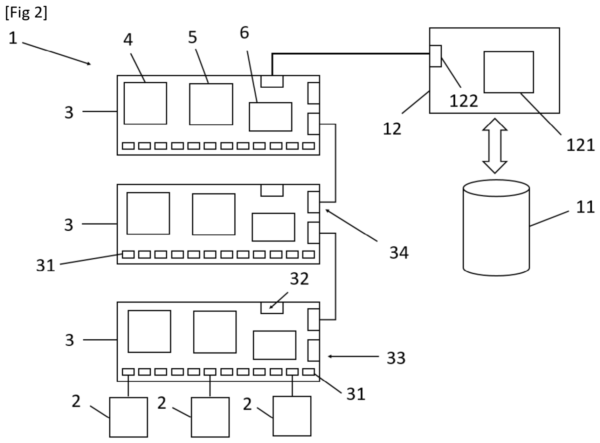

Le procédé de qualification P de l'invention, et le système de qualification 1 le mettant en œuvre, sont respectivement illustrés à l'aide des Figure 1 et Figure 2. De sorte à privilégier la lisibilité des figures, des éléments de l'invention ne sont pas représentés, ou bien sont représentés mais ne sont pas à l'échelle.

Le procédé de qualification P de l'invention permet, à minima, de qualifier l'état de santé SOH1, SOH2 d'au moins un module 2 d'une batterie de type nickel-hydrure métallique NiMH, l'au moins un module comprenant plusieurs cellules cylindriques, ou prismatiques, mises en série, et raccordées entre deux bornes (une borne positive et une borne négative) du module. Le procédé de qualification P et le système de qualification 1 sont prévus pour permettre de qualifier jusqu'à soixante modules 2 simultanément.

Dans le mode de réalisation décrit, le système de qualification 1 comprend une unité de contrôle 12. L'unité de contrôle 12 comprend un programme contenant une liste d'instructions qui, lorsqu'elle est exécutée par l'unité de contrôle 12, permet la mise en œuvre du procédé de contrôle P. L'unité de contrôle comprend également au moins une prise d'entrée

Le système de qualification 1 comprend des racks 3 avec lesquels communique l'unité de contrôle. Chacun des racks 3 présente plusieurs prises d'entrée auxquelles sont raccordées électriquement un ou des module(s) 2 à qualifier ; avec un module 2 raccordé électriquement par prise d'entrée 31. Dans un mode de réalisation, tel qu'illustré Figure 2, les racks 3 sont prévus pour comprendre chacun 12 prises d'entrées, impliquant alors que cinq racks doivent être utilisés en vue de qualifier simultanément soixante module 2s. Dans l'exemple illustré, le système de qualification 1 permettrait la qualification de trente-six modules 2 simultanément. Chacun des racks comprend également une prise de sortie 32.

Chacun des racks 3 comprend au moins un générateur de courant de charge 4 et au moins un générateur de courant de décharge 5 dont les rôles sont précisés par la suite ; avec l'au moins un générateur de courant de charge 4 et l'au moins un générateur de courant de décharge 5 raccordés électriquement aux prises d'entrée 31 au moyen d'au moins un bus de distribution qui est non illustré. L'unité de contrôle est conformée pour commander l'au moins un générateur de courant de charge 4 et l'au moins un générateur de courant de décharge 5 en leur transmettant des signaux de commande ; de sorte à ce qu'ils génèrent et propagent respectivement sur l'au moins un bus de distribution, et donc transmettent aux plusieurs prises d'entrée 31, un courant de charge et un courant de décharge.

Afin que l'unité de contrôle 12 transmettre les signaux de commande à l'au moins un générateur de courant de charge 4 et l'au moins un générateur de courant de décharge 5 de chaque rack 3, l'unité de contrôle 12 peut, dans un mode de réalisation non illustré, comprendre plusieurs prises d'entée 122 tel que la prise de sortie 32 de chacun des racks soit raccordée électriquement et distinctement à une des plusieurs prises d'entrée 122 de l'unité de contrôle 12. Autrement dit, chacun des racks 3 est raccordé électriquement directement à l'unité de contrôle 12.

La transmission des signaux de commande peut être également mise en œuvre en cascadant les racks 3. Pour cela, chacun des racks comprend une prise de parallélisation d'entrée 33 est une prise de parallélisation de sortie 34. La mise en cascade de deux racks 3 est réalisée en raccordant électriquement la prise de parallélisation de sortie 34 d'un des deux racks à la prise de parallélisation d'entrée 33 de l'autre des deux racks 3. Dans l'exemple illustré Figure 2, les trois racks 3 sont mis en cascade. La prise de sortie 32 d'un des trois racks 3 est raccordé électriquement à l'au moins une prise d'entrée 122 de l'unité de contrôle 22. Ainsi, l'unité de contrôle 12 transmet les signaux de commande au rack 3 auquel elle est raccordée physiquement, lequel rack 3 va ensuite relayer lesdits signaux de commande au rack 3 auquel il est physiquement raccordé et ainsi de suite.

Dans un mode de réalisation non illustré, les racks 3 ne sont pas raccordés physiquement à l'unité de contrôle 12, mais sont en communication avec elle. La transmission des signaux de commande se fait alors au moyen d'un protocole de communication sans fil courte distance.

Dans la suite de la description, le déroulement du procédé de qualification P est détaillé en considérant un seul module 2 raccordé électriquement à un rack 3.

Le procédé de qualification P comprend, à minima, une phase de qualification PQ1 pour la qualification de l'état de santé du module 2.

La phase de qualification PQ1 comprend tout d'abord une étape de charge EQ1 au cours de laquelle l'au moins un générateur de courant de charge 4 est commandé par l'unité de contrôle 2 pour délivrer au module 2 le courant de charge pendant une durée de charge. Le courant de charge est un courant continu constant.

Dans un mode de réalisation, un capteur de courant peut être associé à l'au moins un générateur de courant de charge 4, lequel capteur de courant est conformé, durant l'étape de charge EQ1, pour mesurer l'intensité du courant de charge et la communiquer à l'unité de contrôle 12 qui va alors la comparer avec un seuil de courant de charge. Lorsque l'intensité du courant de charge est supérieure au seuil de sécurité de courant de charge, l'unité de contrôle 12 commande alors l'au moins un générateur de courant de charge 4 pour arrêter de délivrer le courant de charge au module 2. Le procédé de qualification P est alors stoppé pour ce module 2. Le contrôle de l'intensité de courant de charge permet de prévenir les risques de surcharge du module 2.

Dans deux variantes de réalisation différente, le courant de charge peut être mesuré en continu ou à intervalle régulier pendant l'étape de charge EQ1.

Suite à l'étape de charge EQ1, le procédé de qualification P comprend une étape de décharge EQ2 au cours de laquelle l'au moins un générateur de courant de décharge 5 est commandé par l'unité de contrôle 2 pour délivrer au module 2 le courant de décharge pendant une durée de décharge. Le courant de décharge est un courant continu constant, par exemple égal à 56 Ampère. Au cours de l'étape de décharge EQ2, un dispositif de mesure de variation de tension associé au module mesure une variation de tension aux bornes de ce dernier, et transmet cette variation de tension à l'unité de contrôle.

Simultanément à l'étape de décharge EQ2 est mise en œuvre une étape de mesure EQ21 durant laquelle est mesuré, par un dispositif de mesure adéquat associé au module 2, au moins un paramètre physique du module 2 ; la valeur de l'au moins un paramètre physique étant transmise par le dispositif de mesure à l'unité de contrôle 12.

L'étape de décharge EQ2 est suivie d'une étape d'identification EQ3 au cours de laquelle l'unité de contrôle 12 consulte une base de données 11 comprenant des variations de tension de référence. Ces variations de tension de référence correspondent à des variations de tension mesurées aux bornes de modules dits de référence pour lesquels ont été appliquées les étapes de charge EQ1 et de décharge EQ2 ; et pour lesquels furent déterminés par la suite leur état de santé respectif, dit état de santé de référence. Pour chacun des modules de références caractérisés, sa variation de tension de référence a été enregistrée dans la base de donnée en étant associée à la valeur déterminée de son état de santé de référence. Pour ces modules de références ont été également mesurés, au cours d'une étape de mesure EQ21, au moins un paramètre physique, puis enregistrée dans la base de données 11 la valeur dudit paramètre physique ; de sorte à ce que les variations de tension de références soient classées dans la base de données 11 en fonction de la valeur de l'au moins un paramètre physique.

Cet au moins un paramètre physique est également mesuré pour le module 2 en cours de qualification.

Ainsi, lorsqu'elle consulte la base de données 11, l'unité de contrôle 12 opère une présélection des variations de tension de référence dont la valeur de l'au moins un paramètre physique associée est égale, ou équivalente (par exemple à plus ou moins 10% près) à celle mesurée pour le module 2.

Dans le mode de réalisation décrit, l'au moins un paramètre physique considéré pour les modules de référence et le module 2 correspond à leur température.

L'étape de mesure EQ21 est mise en œuvre après l'étape de décharge EQ2 et précède l'étape d'identification EQ3. Durant l'étape de mesure EQ21, un capteur de température qui est associé au module 2 mesure la température de ce dernier, puis transmet la valeur de la température à l'unité de contrôle 12.

Dans un autre mode de réalisation, l'au moins un paramètre physique peut correspondre à une mesure de tension en circuit ouvert aux bornes du module. L'étape de mesure EQ21 est alors mise en œuvre avant l'étape de charge EQ1. Un capteur de tension peut être associé au module 2 et conformé pour mesurer la tension en circuit ouvert, puis la transmettre à l'unité de contrôle 12.

A noter que dans un mode de réalisation de l'invention, les variations de tension de référence peuvent être également pré-classées dans la base de données en fonction du type de cellule comprise dans le module 2 (cellule prismatique ou cellule cylindrique).

Puis, l'unité de contrôle 12 compare la variation de tension du module 2 en cours de qualification avec les variations de tension de référence qu'elle a sélectionnées au moyen d'une fonction de similarité. L'unité de contrôle 12 identifie alors une variation de tension de référence, dite variation de tension de référence proche, pour laquelle la fonction de similarité est la plus élevée, c'est-à-dire pour laquelle la fonction de similarité offre le meilleur résultat.

Suite à l'étape d'identification EQ3, la phase de qualification PQ1 comprend enfin une étape de qualification EQ4 au cours de laquelle l'unité de contrôle 12 qualifie l'état de santé SOH1 du moule 2 comme étant égal à l'état de santé de référence (plus précisément, la valeur de l'état de santé de référence) associé à la variation de tension de référence proche.

A l'issue de la phase de qualification PQ1 est mise en œuvre une étape de détermination C1 au cours de laquelle l'unité de contrôle 12 détermine, en fonction de la valeur de l'état de santé SOH1 du module 2, est potentiellement régénérable ou non régénérable. Dans un mode de réalisation, l'unité de contrôle détermine que le module 2 est non régénérable lorsque son état de santé est inférieur à 30% de la capacité nominale du module, plus ou moins 10%. Lorsque le module 2 est déterminé comme non régénérable, il est mis au rebut au cours d'une étape de mise au rebut E9.

Dans un mode de réalisation favori de l'invention, le procédé de qualification P comprend, suite à la phase de régénération PQ1, une phase de régénération PR dans le but de restaurer la capacité nominale d'un module 2 (ou du moins que le gain en capacité obtenu suite à la phase de régénération PR soit suffisant pour un fonctionnement correct/nominal du module 2) lorsque celui-ci a été déterminé comme potentiellement régénérable. Comme expliqué ultérieurement, à l'issue de la phase de régénération, l'état de santé du module est à nouveau qualifié suite à la phase de régénération PR.

Autrement dit, dans ce mode de réalisation favori, le procédé comprend une première phase de qualification PQ1 au cours de laquelle est qualifié l'état de santé, dit état de santé initial SOH1, d'un module pour déterminer s'il est potentiellement régénérable ou non ; et une deuxième phase de qualification PQ2 à au cours de laquelle est qualifié à nouveau l'état de santé, appelé état de santé final SOH2, du module 2 après régénération.

La phase de régénération PR comprend tout d'abord une étape de décharge ER1 au cours de laquelle est délivré au module 2 un courant de décharge, pouvant par exemple correspondre à un courant continu constant dont l'intensité est différente selon que le module 2 à régénérer comprend des cellules cylindriques ou des cellules prismatiques

Le courant de décharge peut être délivré par l'au moins un générateur de courant de décharge 5 ayant délivré le courant de décharge au cours de l'étape de décharge EQ2 de la première phase de qualification PQ1, ou bien par générateur de courant de décharge différent. Pendant l'étape de décharge ER1, le dispositif de mesure de variation de tension associé au module 2, en continu, mesure et transmet à l'unité de contrôle 12 la variation de tension aux bornes de celui-ci. L'unité de contrôle 12 stoppe l'étape de décharge ER1 dès lors que la variation de tension du module 2 devient inférieure ou égale à une tension seuil de module. La tension de module peut par exemple être égale à 1Volt/cellule. Lorsque le module 2 comprenant des cellules prismatiques (respectivement des cellules cylindriques), la tension de module est égale à 6 Volt (respectivement 4 Volt).

La phase de régénération PR se poursuit, après l'étape de décharge ER1, avec une étape de charge de régénération ER2 durant laquelle l'unité de contrôle 12 commande au moins un générateur de courant de charge de régénération 6, que comprend le rack 3 auquel est raccordé électriquement le module 2, pour délivrer au module 2, pendant une durée de régénération, un courant de charge de régénération sous la forme d'un train d'impulsions comprenant des impulsions en courant successives définies par une amplitude d'impulsion et une durée d'impulsion.

Pendant l'étape de charge de régénération ER2 peuvent être mesurées, en continu ou régulièrement :
- la température du module par le capteur de température qui lui est associé, celle-ci augmentant avec l'application du courant de charge de régénération ; et/ou
- la tension aux bornes du module au moyen d'un capteur de tension associé au module, et qui est en communication avec l'unité de contrôle 12 pour lui transmettre la tension mesurée ; et/ou
- l'amplitude d'impulsion (autrement dit, l'intensité) des impulsions du courant de charge de régénération par un capteur de courant associé à l'au moins un générateur de courant de charge de régénération, et qui est en communication avec l'unité de contrôle 12 pour lui transmettre l'amplitude d'impulsion mesurée.

L'unité de contrôle 12 compare alors :
- la température du module2 avec une température seuil haute, et/ou
- la tension du module 2 avec une autre tension seuil de module, et/ou
- l'amplitude d'impulsion avec une amplitude seuil d'impulsion.

L'unité de contrôle 12 et configurée pour stopper l'étape de charge de régénération ER2 lorsque :
- la température du module 2 est supérieure ou égale à la température de seuil haute, dans le but de prévenir un risque de surchauffe du module ; et/ou
- le tension aux bornes du module est supérieure ou égale à l'autre seuil de tension, dans le but de prévenir un risque de surtension du module ; et/ou
- l'amplitude d'impulsion est supérieure ou égale à l'amplitude seuil d'impulsion, dans le but de prévenir un risque de surintensité au niveau du module.

Lorsqu'un de ces risques est détecté, l'unité de contrôle 12 stoppe l'étape de charge de régénération ER2. Le procédé de qualification P est alors arrêté pour le module 2. Autrement dit, la phase de régénération PR n'est pas poursuivie et la deuxième phase de qualification n'est pas mise en œuvre pour le module 2.

Lorsqu'aucun risque n'a été détecté pendant l'étape de charge de régénération ER2, une fois celle-ci achevée, la phase de régénération se conclut par une étape de repos ER3 durant laquelle le module 2 est laissé au repos pour qu'il refroidisse jusqu'à ce que sa température devienne inférieure ou égale à un seuil de température basse.

Une fois que la température du module 2 est inférieure ou égale à un seuil de température basse, la deuxième phase de qualification PQ2 est mise en œuvre pour qualifier l'état de santé final SOH2 du module 2. La deuxième phase de qualification PQ2 se déroule de manière identique à la première phase de qualification PQ1, en comprenant successivement les étapes de charge EQ1, de décharge EQ2, d'identification EQ3, et de qualification EQ4.

A noter qu'au cours de l'étape de charge EQ1, l'application du courant de charge au module a pour effet d'augmenter sa température. C'est pourquoi, afin de prévenir un risque de surchauffe du module 2 au cours l'étape de charge EQ1 de la deuxième phase de qualification PQ2, ladite étape de charge EQ1 est précédée de l'étape de repos ER3.

A l'issue de la deuxième phase de qualification PQ2, au cours d'une deuxième étape de détermination C2, l'unité de contrôle 12 détermine, en fonction de la valeur de l'état de santé final, si le module 2 est potentiellement régénérable ou non régénérable. Lorsque le module 2 est non régénérable, il est mis au rebut.

Dans le mode de réalisation favori, le module 2 est considéré comme potentiellement régénérable (et non pas comme régénérable) lorsque l'état de santé final SOH2 est supérieur ou égal à un seuil de santé minimal, qui correspond à 0,8 fois un état de santé nominal du module 2 (autrement dit, lorsque l'état de santé final SOH2 est supérieur ou égal à 80% de la capacité nominale du module 2).

En effet, la validation de la valeur de l'état de santé final SOH2 est une condition nécessaire mais non suffisante pour déterminer que le module 2 est régénérable. Bien que le gain en capacité obtenu suite à la phase de régénération PR soit suffisant, il n'est pas garanti que le module 2 soit apte à fournir rapidement de la puissance sur de courtes durées, par exemple dans le contexte applicatif de l'alimentation d'un véhicule hybride électrique auto-rechargeable.

Afin d'évaluer l'aptitude du module 2 potentiellement régénérable à fournir rapidement de la puissance sur de courtes durées, le procédé de qualification P comprend, suite à la deuxième étape de détermination C2, au moins une étape de décharge additionnelle E5 durant laquelle, pendant une durée de décharge additionnelle : est délivré au module un courant de décharge additionnel ; et mesuré simultanément une tension instantanée aux bornes du module 2, laquelle est ensuite transmise à l'unité de contrôle 12. La mesure et la transmission à l'unité de contrôle 12 de la tension mesurée peuvent par exemple être mises en œuvre par un capteur de tension associé au module 2. Le courant de décharge additionnel peut être délivré par l'au moins un générateur de courant de décharge 5, ou bien par au moins un générateur de courant de décharge additionnel compris dans le rack 3 commandé par l'unité de contrôle 12.

L'unité de contrôle 12 détermine alors que le module est :
- régénéré lorsque la tension instantanée, pendant la durée de décharge additionnelle, est stable et supérieure à la tension seuil de module (par exemple, 1 Volt/cellule comme précédemment indiqué) ; ou
- non régénéré lorsqu'au moins, pendant la durée de décharge additionnelle, la tension instantanée varie, ou est inférieure ou égale à la tension seuil de module.

Le module 2 est mis au rebut s'il est non régénéré à l'issue de l'au moins une étape de charge additionnelle E5.

Dans un mode de réalisation, l'au moins une étape de décharge additionnelle E5 peut reproduire les conditions réelles d'utilisation du module 2 lorsqu'il doit alimenter électriquement un véhicule hybride électrique auto-rechargeable ; la durée de décharge additionnelle étant définie en fonction de ces conditions.

Lorsque plusieurs étapes de décharge additionnelles E5 sont successivement mises en œuvre, le module 2 est déterminé comme régénéré lorsque sa tension instantanée est stable et supérieure à la tension seuil de module pendant la durée de décharge additionnelle pour chacune des plusieurs étapes de décharge additionnelles E5. Inversement, le module 2 est déterminé comme non régénéré lorsque, pour au moins une étape de décharge additionnelle E5 parmi les plusieurs étapes de charge additionnelle E5, la tension instantanée varie, ou est inférieure ou égale à la tension seuil de module pendant la durée de décharge additionnelle.

Lorsque le module 2 a été déterminé comme régénéré, le procédé de qualification P comprend une dernière étape correspondant à une étape de charge additionnelle E6, dans le but de charger le module. En effet, la mise en œuvre de l'au moins une étape de décharge additionnelle E5 a pour conséquence de diminuer l'état de charge SOC du module 2. L'étape de charge additionnelle E6 consiste à délivrer au module 2 un courant de charge additionnel jusqu'à ce que son état de charge SOC soit égal à une portion de l'état de santé final SOH2, par exemple 0,6 fois l'état de santé final SOH2.

Le courant de charge additionnel peut être un courant continu constant.

Selon différentes variantes de réalisation, le courant de charge additionnel peut-être fourni :
- par l'au moins un générateur de courant de charge ; ou bien
- par au moins un générateur de courant de charge additionnel compris dans le rack 3 et commandé par l'unité de contrôle 12.

Pendant l'étape de charge additionnelle E6, une mesure et une transmission de la valeur, en continu ou à intervalle régulier, du courant de charge additionnel à l'unité de contrôle 12 peuvent être mises en œuvre de sorte que celle-ci compare la valeur à un autre seuil de sécurité de courant de charge. L'unité de contrôle 12 est alors configurée pour stopper l'étape de charge additionnelle E6 lorsque la valeur du courant de charge additionnel est supérieure à l'autre seuil de sécurité de courant de charge, afin de prévenir un risque de surcharge du module 2.

Avantageusement, le procédé de qualification P de l'invention permet, comparativement aux procédés de qualification de l'existant, de qualifier l'état de santé d'un module 2 sans mettre en œuvre successivement plusieurs cycles de charge complète et de décharge profonde du module 2 qui sont consommateurs en temps et peuvent le stresser et accélérer son vieillissement, voire dans le pire cas l'endommager.

Dans le contexte applicatif d'une qualification de l'état de santé d'un module de batterie NiMH d'un véhicule hybride électrique auto-rechargeable, la mise en œuvre de la phase de qualification PQ1, PQ2 du procédé de qualification P dure avantageusement moins d'une dizaine de minutes, comparativement aux procédés de qualification usuels qui durent une dizaine d'heures. Ainsi, le procédé de qualification P permet de qualifier plus rapidement successivement plusieurs modules 2.

Outre un gain de temps, la phase de qualification PQ1, PQ2 du procédé de qualification P de l'invention, comparativement aux procédés de qualification usuels, permet de réduire, pour de réduire significativement la consommation d'énergie des équipements utilisés pour charger et décharger les modules 2.

Par exemple, l'au moins un générateur de courant de charge 4 et l'au moins un générateur de courant de décharge 5 consomment de l'énergie respectivement au cours d'une seule étape de charge EQ1 et d'une seule étape de décharge EQ2, par ailleurs pour des durées de charge et décharge relativement courtes ; alors que dans les procédés de qualification usuel, les générateurs de courant consomment de l'énergie pendant des cycles successifs de charge/décharge pouvant durer plusieurs heures.

Comme indiqué auparavant, le procédé de qualification P, et le système de qualification 1 associé, permettent de qualifier (et régénérer selon le mode de réalisation) plusieurs modules 2 simultanément. Un autre avantage du procédé de qualification P est de pouvoir être appliqué de manière indépendante aux plusieurs modules.

Dans un contexte applicatif, la mise en œuvre de la phase de qualification PQ1, PQ2 peut par exemple débuter pour un module 2 venant d'être raccordé électriquement à un rack 3, alors qu'elle est déjà en cours pour d'autres modules déjà raccordés électriquement audit rack 3.

Dans un autre contexte applicatif, la phase de qualification PQ1, PQ2 peut être mise en œuvre pour au moins module 2 parmi plusieurs modules 2 raccordé électriquement à un rack 3, alors que la phase de régénération PR est mise en œuvre pour un autre module 2 parmi les plusieurs modules.

Dans un autre contexte applicatif, le procédé de qualification peut être stoppé pour un module 2 raccordé électriquement à un rack 3, parce qu'il a été déterminé comme non régénérable ou parce qu'un risque (de surchauffe, de surcharge, etc.) a été détecté, et se poursuivre pour d'autres modules 2 raccordés électriquement à ce même rack 3.

Le traitement indépendant de plusieurs modules 2 permet un gain de temps significatif dans la mise en œuvre de la phase de qualification PQ1, PQ2, et de la phase de régénération si elle est considérée PR.

Bien que la présente invention ait été décrite en se référant à des modes de réalisation spécifiques, il est évident que des modifications et des changements peuvent être effectués sur ces exemples sans sortir de la portée générale de l'invention telle que définie par les revendications. En particulier, des caractéristiques individuelles des différents modes de réalisation illustrés/mentionnés peuvent être combinées dans des modes de réalisation additionnels. Par conséquent, la description et les dessins doivent être considérés dans un sens illustratif plutôt que restrictif.

Il est également évident que toutes les caractéristiques décrites en référence au procédé de qualification P sont transposables, seules ou en combinaison, au système de qualification 1 ; et réciproquement.

## Revendications

1. Procédé de qualification (P) pour qualifier un état de santé (SOH1, SOH2) d'au moins un module (2) d'une batterie de type nickel-hydrure métallique, lequel au moins un module (2) comprenant plusieurs cellules mises en série, ledit procédé de qualification (P) étant mis en œuvre par un système de qualification (1) qui comprend une base de données (11) et auquel est raccordé électriquement l'au moins un module (2), et ledit procédé de qualification (P) comprenant au moins une phase de qualification (PQ1, PQ2) à l'issue de laquelle est déterminé l'état de santé (SOH1, SOH2) de l'au moins un module (2), laquelle phase de qualification (PQ1, PQ2) comprenant les étapes successives suivantes :
- une étape de charge (EQ1) au cours de laquelle le système de qualification (1) applique à l'au moins un module (2) un courant de charge pendant une durée de charge ;
- une étape de décharge (EQ2) au cours de laquelle, pendant une durée de décharge, le système de qualification (1) applique à l'au moins un module (2) un courant de décharge et mesure simultanément une variation de tension aux bornes de l'au moins un module (2) ;
- une étape d'identification (EQ3) durant laquelle le système de qualification (1) compare la variation de tension aux bornes de l'au moins un module (2) à des variations de tension de référence au moyen d'une fonction de similarité, lesquelles variations de tension de référence étant contenues dans la base de données (11) et étant chacune associée à un état de santé de référence, puis identifie l'une des variations de tension de référence, dite variation de tension de référence proche, pour laquelle la fonction de similarité est la plus élevée ;
- une étape de qualification (EQ4) durant laquelle le système de qualification (1) qualifie l'état de santé (SOH1, SOH2) de l'au moins un module (2) comme égal à l'état de santé de référence associé à la variation de tension de référence proche ;
l'au moins un module (2) étant déterminé à l'issue de la phase de qualification (PQ1, PQ2) comme potentiellement régénérable ou non régénérable en fonction de l'état de santé déterminé (SOH1, SOH2).

2. Procédé de qualification (P) selon la revendication 1, comprenant, avant l'étape d'identification (EQ3), une étape de mesure (EQ21) durant laquelle le système de qualification (1) mesure une valeur d'au moins un paramètre physique de l'au moins un module (2), où les variations de tension de référence contenues dans la base de données (11) sont toutes associées à une valeur dudit au moins un paramètre physique, et dans lequel, durant l'étape d'identification (EQ3), il est opéré une présélection des variations de tension de référence dont la valeur de l'au moins un paramètre physique est équivalente à la valeur de l'au moins un paramètre physique mesurée lors de l'étape de mesure (EQ21).

3. Procédé de qualification (P) selon la revendication 1 ou 2, dans lequel le procédé de qualification (P) comprend une mesure du courant de charge durant l'étape de charge (EQ1) ; l'étape de charge (EQ1) étant stoppée lorsque le courant de charge dépasse un seuil de sécurité de courant de charge donné.

4. Procédé de qualification (P) selon l'une quelconque des revendications 1 à 3, dans lequel la phase de qualification (PQ1, PQ2) est mise en œuvre une première fois pour établir l'état de santé de l'au moins un module (2), appelé état de santé initial (SOH1), et une seconde fois pour établir l'état de santé de l'au moins un module, appelé état de santé final (SOH2), et entre les deux phases de qualification, dites respectivement première phase de qualification (PQ1) et deuxième phase de qualification (PQ2), est mise en œuvre une phase de régénération (PR) comprenant successivement :
- une étape de décharge (ER1) au cours de laquelle le système de qualification (1) applique à l'au moins un module (2) un courant de décharge et mesure simultanément la variation de tension aux bornes de l'au moins un module (2), l'étape de décharge (ER1) étant mise en œuvre jusqu'à ce que la variation de tension aux bornes de l'au moins un module (2) devienne inférieure ou égale à une tension seuil de module ;
- une étape de charge de régénération (ER2) durant laquelle le système de qualification (1) applique, pendant une durée de régénération prédéfinie, à l'au moins un module (2) un courant de charge de régénération sous la forme d'un train d'impulsions comprenant des impulsions en courant successives définies par une amplitude d'impulsion et une durée d'impulsion, et
- une étape de repos (ER3) durant laquelle l'au moins un module (2) est laissé au repos de sorte que l'au moins un module (2) présente une température inférieure ou égale à une température seuil basse ;
la phase de régénération (PR) et la deuxième phase de qualification (PQ2) étant mises en œuvre à la condition que le système de qualification (1) ait déterminé que l'au moins un module (2) est potentiellement régénérable à l'issue de la première phase de qualification (PQ1) ; et
le système de qualification (1) déterminant, à l'issue de la deuxième phase de qualification (PQ2), que l'au moins un module (2) : est potentiellement régénérable lorsque l'état de santé final (SOH2) est supérieur à un seuil de santé minimal ; ou bien non régénérable lorsque l'état de santé final (SOH2) est inférieur ou égal au seuil de santé minimal.

5. Procédé de qualification (P) selon la revendication 4, dans lequel le seuil de santé minimal est supérieur ou égal à 0.8 fois un état de santé nominal de l'au moins un module, lequel état de santé nominal est par exemple égal à 1.

6. Procédé de qualification (P) selon la revendication 4 ou 5, dans lequel, parallèlement à l'étape de charge de régénération (ER2) de la phase de régénération (PR), le système de qualification (1) met en œuvre au moins une étape de mesure parmi les étapes de mesure suivantes :
- mesurer la température de l'au moins un module (2), puis la comparer à une température seuil haute, ou
- mesurer une tension de l'au moins un module (2), puis la comparer à une autre tension seuil de module, ou
- mesurer l'amplitude d'impulsion des impulsions du courant de charge de régénération, puis la comparer à une amplitude seuil d'impulsion ;
le phase de régénération (PR) étant stoppée et la deuxième phase de qualification (PQ2) n'étant pas mise en œuvre lorsqu'au moins : la température de l'au moins un module (2) est supérieure ou égale à la température seuil haute, ou la tension de l'au moins un module (2) est supérieure ou égale à l'autre tension seuil de module, ou l'amplitude d'impulsion est supérieure ou égale à l'amplitude seuil d'impulsion.

7. Procédé de qualification (P) selon l'une quelconque des revendications 4 à 6, dans lequel, lorsque l'au moins un module (2) est déterminé comme potentiellement régénérable à l'issue de la deuxième phase de qualification (PQ2), le procédé de qualification (P) comprend au moins une étape de décharge additionnelle (E5) durant laquelle le système de qualification (1) applique, pendant une durée de décharge additionnelle prédéfinie, un courant de décharge additionnel à l'au moins un module (2), et mesure simultanément une tension instantanée de l'au moins un module (2) ; l'au moins un module étant déterminé par le système de qualification (1) comme :
- régénéré lorsque la tension instantanée est stable et supérieure à la tension seuil de module pendant la durée de décharge additionnelle, ou bien
- non régénéré lorsqu'au moins, pendant la durée de décharge additionnelle, la tension instantanée varie, ou est inférieure ou égale à la tension seuil de module.

8. Procédé de qualification (P) selon la revendication 7, dans lequel l'au moins un module présente un état de charge (SOC), et dans lequel le procédé de qualification (P) comprend, à l'issue de l'au moins une étape de décharge additionnelle (E5) et lorsque l'au moins un module (2) est déterminé comme étant régénéré, une étape de charge additionnelle (E6) durant laquelle le système de qualification (1) applique à l'au moins un module (2) un courant de charge additionnel jusqu'à ce que l'état de charge (SOC) de l'au moins un module soit égal à une portion de l'état de santé final (SOH2).

9. Procédé de qualification (P) selon la revendication 8, dans lequel la portion de l'état de santé final (SOH2) est comprise entre 0,5 et 0,7 fois l'état de santé final (SOH2).

10. Procédé de qualification (P) selon la revendication 8 ou 9, dans lequel, le procédé de qualification (P) comprend une mesure du courant de charge additionnel durant l'étape de charge additionnelle (E6) ; l'étape de charge additionnelle (E6) étant stoppée lorsque le courant de charge additionnel dépasse un autre seuil de sécurité de courant de charge donné.

11. Procédé de qualification (P) selon l'une quelconque de revendications précédentes, dans lequel l'au moins un module (2) comprend plusieurs modules (2) tels que le procédé de qualification (P) est mis en œuvre pour chacun des plusieurs modules (2) de manière indépendante.

12. Procédé de qualification (P) selon la revendication 11, dans lequel les plusieurs modules (2) comprennent entre 2 modules et 60 modules (2).

13. Procédé de qualification (P) selon l'une quelconque des revendications précédentes, dans lequel les plusieurs cellules de l'au moins un module (2) sont des cellules cylindriques, ou des cellules prismatiques.

14. Système de qualification (1) pour une qualification d'au moins un module (2) d'une batterie de type nickel-hydrure métallique, avec l'au moins un module (2) comprenant plusieurs cellules mises en série, le système de qualification (1) comprenant une base de données (11), au moins un générateur de courant de charge (4), au moins un générateur de courant de décharge (5), et au moins une prise d'entrée (31) pour raccorder électriquement l'au moins un module (2) au système de qualification (2) ; le système de qualification (1) comprenant également une unité de contrôle (12) au moins en communication avec la base de données (11), l'au moins un générateur de courant de charge (4) et l'au moins un générateur de courant de décharge (5), laquelle unité de contrôle (12) comprenant un programme (121) contenant une liste d'instructions qui, lorsqu'elles sont exécutées par l'unité de contrôle (12), mettent en œuvre le procédé de qualification (P) selon l'une quelconque des revendications précédentes.
